# EUROPEAN PATENT APPLICATION

(11) **EP 1 936 679 A1**
(43) Date of publication of application: **25.06.2008**
(21) Application number: 07023462.0
(22) Date of filing: 04.12.2007
(51) Int. Cl.: H01L 21/762

(54) **Method for manufacturing an SOI substrate**

(30) Priority: 18.12.2006 JP 2006339370
(71) Applicant: Shinetsu Chemical Co., Ltd., Tokyo 100-0004 (JP)
(72) Inventor: Akiyama, Shoji, Annaka-shi, Gunma-ken (JP); Kubota, Yoshihiro, Annaka-shi, Gunma-ken (JP); Ito, Atsuo, Annaka-shi, Gunma-ken (JP); Tanaka, Koichi, Annaka-shi, Gunma-ken (JP); Kawai, Makoto, Annaka-shi, Gunma-ken (JP); Tobisaka, Yuuji, Annaka-shi, Gunma-ken (JP)
(74) Representative: Wibbelmann, Jobst

(57) **Abstract**

The present invention enables reducing a temperature in a manufacturing process of an SOI substrate.
A hydrogen ion is implanted into a surface of a single-crystal Si substrate 10 via an oxide film 11 to form a uniform ion implantation layer 12 at a predetermined depth near a surface of the single-crystal Si Substrate 10. At this time, ion implantation is carried out under a condition that a temperature of the Si substrate 10 is maintained so as not to exceed 400°C. Subsequently, a heat treatment is performed with respect to the single-crystal Si substrate 10 at a temperature of 400°C or below. This heat treatment is effected to weaken mechanical strength of an "implantation interface" of the ion implantation layer 12 in advance prior to a delamination step, and the heat treatment temperature is set to 400°C or below in order to suppress occurrence of "micro cavities" and "air bubble growth". A plasma treatment or an ozone treatment is carried out to joint surfaces of both substrates, and an external impact shock is given in a state where the substrates are bonded to each other to mechanically delaminate a silicon film 13 from a bulk 14 of the single-crystal silicon, thereby obtaining an SOI film 13 provided on a quartz substrate 20 via the oxide film 11.

## Description

### BACKGROUND OF THE INVENTION

### 1. Field of the Invention

The present invention relates to a method for manufacturing an SOI substrate having a silicon film on an insulator substrate.

### 2. Description of the Related Art

As a semiconductor substrate that enables offering technical advantages of a semiconductor device, a Silicon On Insulator (SOI) wafer is gathering attention. That is because a parasitic capacitance can be reduced, an operating speed can be improved, and power consumption can be suppressed by adopting an SOI structure to bury an oxide film under a single-crystal silicon thin film. However, up to the present day, the SOI wafer does not become a mainstream of an LSI device manufacturing substrate. That is because a manufacturing cost of the SOI wafer is approximately several-fold (or above) of a manufacturing cost of a regular Si wafer.

Further, a Silicon On Quartz (SOQ) wafer having a silicon thin film on a quartz substrate is an SOI wafer which is expected to be applied to an optical device, e.g., a TFT liquid crystal monitor manufacturing device and recently gathers attention as a semiconductor substrate having an intended purpose different from that of a regular SOI wafer, but this SOQ wafer likewise has a problem of a high manufacturing cost.

As a method of bonding two substrates to manufacture an SOI substrate, there has been conventionally known an SOITEC method (a SmartCut method) of bonding a silicon substrate having an hydrogen ion implanted into a bonding surface side to a handling substrate, and performing a heat treatment at approximately 500°C or above to thermally delaminate a silicon thin film from a region having the highest implanted hydrogen ion concentration, and this method is based on a mechanism of heating high-density "air bubbles" called "micro cavities" formed by implantation of the hydrogen ion to "grow" and utilizing this "air bubble growth" to delaminate the silicon thin film (see Japanese Patent Publication No. 3048201 and A.J. Auberton-Herve et al., "SMART CUT TECHNOLOGY: INDUSTRIAL STATUS of SOI WAFER PRODUCTION and NEW MATERIAL DEVELOPMENTS" (Electrochemical Society Proceedings Volume 99-3 (1999) p. 93-106).).

However, the SOITEC method has a problem requiring many high-temperature processes, and this is a factor of increasing the manufacturing cost of the SOI substrate. Furthermore, according to the SOITEC method, although thermal delamination is carried out along a hydrogen ion implantation interface at a temperature close to 450°C after bonding the silicon substrate to an insulator substrate (a support substrate formed of, e.g., quartz or sapphire), when a heat treatment is carried out at a temperature close to 450°C in a state where the silicon substrate is bonded to a substrate having a different thermal expansion coefficient, e.g., a quartz substrate, a thermal damage due to a difference in thermal expansion coefficient between both the substrates occurs, and delamination or a crack of bonding surfaces is apt to occur due to this thermal damage.

Therefore, although completing delamination of the silicon thin film in a process at a relatively low temperature is desirable, a heat treatment at a relatively high temperature must be generally performed in a state where both the substrates are bonded to each other in order to provide an excellent bonded state of the entire bonding surfaces of the silicon substrate and the insulator substrate and give sufficient bonding strength.

That is, when bonding the silicon substrate to the insulator substrate to fabricate the SOI substrate, there is a problem that a demand for realization of a low-temperature process required to avoid, e.g., delamination or a crack of the bonding surfaces due to a thermal damage produced by a difference in thermal expansion coefficient between both the substrates and a heat treatment at a relatively high temperature which is required to provide the excellent bonded state of the entire bonding surfaces have a contradictory relationship, and the SOITEC method cannot solve this problem. Moreover, when using an inexpensive glass substrate or an organic film substrate as the insulator substrate, realization of a low-temperature process is a necessary condition because a melting point of this substrate is low, but the conventional method requiring a high-temperature process hardly copes with this problem.

### SUMMARY OF THE INVENTION

In view of the above-explained problems, it is an object of the present invention to realize a low-temperature process in a method for manufacturing an SOI substrate.

To solve this problem, according to the present invention, the present invention comprises: an ion implantation step of forming a hydrogen ion implanted layer on a main surface of a silicon substrate; a surface treatment step of performing an activation treatment to the main surface of at least one of an insulator substrate and the silicon substrate; a bonding step of bonding the main surfaces of the insulator substrate and the silicon substrate to each other; and a delamination step of mechanically delaminating a silicon thin film from the silicon substrate of the bonded substrate to form a silicon film on the main surface of the insulator substrate, wherein a temperature of the silicon substrate at the ion implantation step is maintained at 400°C or below.

In the method for manufacturing an SOI substrate according to the present invention, it is preferable that a step of performing a heat treatment to the silicon substrate at a temperature equal to or below 400°C after the ion implantation step and before the bonding step.

In the method for manufacturing an SOI substrate according to the present invention, it is preferable that a temperature of the silicon substrate at the ion implantation step falls within the range of 200°C to 400°C.

In the method for manufacturing an SOI substrate according to the present invention, it is preferable that the activation treatment is carried out based on at least one of a plasma treatment and an ozone treatment.

In the method for manufacturing an SOI substrate according to the present invention, it is preferable that a step of performing a heat treatment at a temperature of 400°C or below in a state where the insulator substrate and the silicon substrate are bonded to each other after the bonding step and before the delamination step.

In the method for manufacturing an SOI substrate according to the present invention, it is preferable that the silicon substrate has a silicon oxide film on the main surface thereof.

In the method for manufacturing an SOI substrate according to the present invention, it is preferable that a thickness of the silicon oxide film is 0.2 µm or above.

In the method for manufacturing an SOI substrate according to the present invention, it is preferable that the insulator substrate is any one of a high resistivity silicon substrate, a silicon substrate with an oxide film, a quartz substrate, a sapphire substrate, a glass substrate, and an organic film substrate.

According to the present invention, since a temperature in the manufacturing process of the SOI substrate is lowered, the manufacturing cost can be reduced, delamination in a region having a relatively high temperature observed in a conventional method is no longer necessary, and hence surface roughness of the SOI film after delamination can be suppressed, thus assuring a uniform thickness of the SOI film on the entire SOI substrate surface.

Additionally, since the low-temperature process is consistently provided, occurrence of a transcribe defect or a slip dislocation can be suppressed, thereby obtaining the high-quality SOI substrate.

### BRIEF DESCRIPTION OF THE DRAWINGS

FIG. 1 is a view for explaining a process example of a method for manufacturing an SOI substrate according to the present invention; and
FIGS. 2 are a cross-sectional view (A) for explaining an outline of a state of a bonding surface of a single-crystal Si Substrate used in the method for manufacturing an SOI substrate according to the present invention, and a cross-sectional schematic view (B) of an SOI substrate including a silicon film obtained by delamination.

### DETAILED DESCRIPTION OF THE PREFERRED EMBODIMENTS

A method for manufacturing an SOI substrate according to the present invention will now be explained based on embodiments. It is to be noted that an insulator substrate will be explained as a quartz substrate in the following embodiments, but the insulator substrate used in the present invention may be a high resistivity silicon substrate, a silicon substrate with an oxide film, a sapphire substrate, a glass substrate, or an organic film substrate.

### Example 1

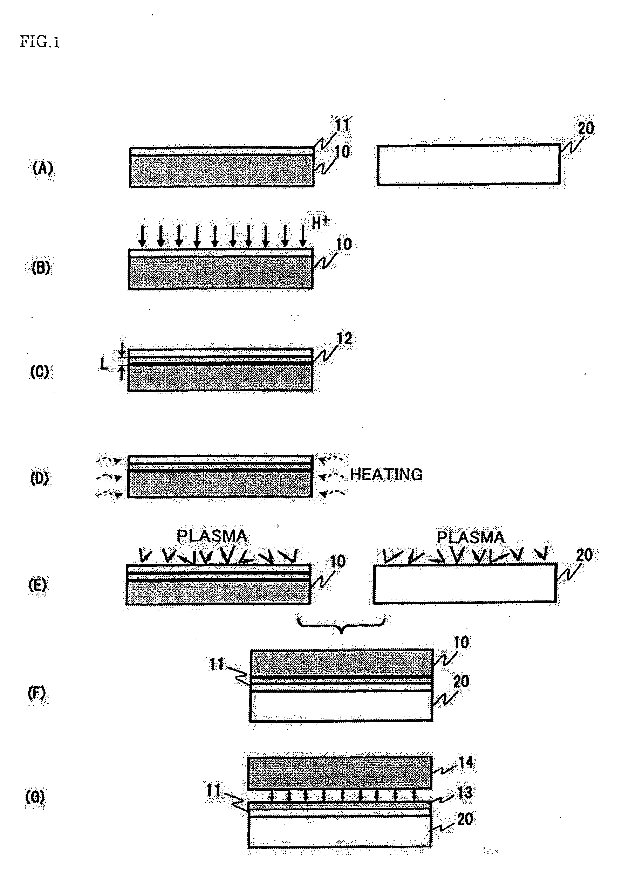

FIG. 1 is a view for explaining a process example of a method for manufacturing an SOI substrate according to the present invention. It is to be noted that an oxide film is provided on a surface of a silicon substrate in advance in this embodiment, but the oxide film is not fundamental, and a general silicon substrate having no oxide film provided thereon may be used.

A silicon substrate 10 depicted in FIG. 1(A) is generally a single-crystal Si substrate, and a support substrate is a quartz substrate 20. Here, the single-crystal Si substrate 10 is a generally commercially available Si substrate grown based on, e.g., a Czochralski method (CZ method), a conductivity type, an electrical characteristic value such as a specific resistivity, a crystal orientation, or a crystal diameter thereof is appropriately selected depending on a device design value or a process to which the SOI substrate manufactured by the method according to the present invention is subject or a surface area of a device to be produced. It is to be noted that an oxide film 11 is formed on a surface (a bonding surface) of this single-crystal Si substrate 10 by, e.g., thermal oxidation in advance as explained above.

The single-crystal Si substrate 10 and the quartz substrate 20 to be bonded to each other have the same diameter, the same orientation flat (OF) as that of the single-crystal Si substrate 10 is also provided to the quartz substrate 20 to facilitate a subsequent device formation process, and boding the substrates to each other so that these OFs match with each other is preferable.

First, under a condition where a temperature of the Si substrate 10 is maintained so as not to exceed 400°C (400°C or below), a hydrogen ion is implanted into a surface of the single-crystal Si substrate 10 through the oxide film 11 (FIG. 1(B)). This ion implanted surface serves as a later-explained "joint surface (the bonding surface)". Based on hydrogen ion implantation, a uniform ion implantation layer 12 is formed at a predetermined depth (an average ion implanted depth L) near the surface of the single-crystal Si substrate 10 (FIG. 1(C)). Although a "micro air bubble layer" which is locally present in a region corresponding to the average ion implanted depth L in the surface region of the single-crystal Si substrate 10 is formed due to generation of crystal defects and micro cavities by implanted hydrogen in silicon according to the conventional method, maintaining a temperature of the Si substrate 10 during the ion implantation process to 400°C or below as explained above enables considerably suppressing generation of the "micro cavities". It is to be noted that a temperature of the single-crystal Si substrate 10 during hydrogen ion implantation is set to fall within the range of 200°C to 400°C.

As a dose amount at the time of hydrogen ion implantation, an appropriate value is selected from the range of, e.g., 1×10¹⁶ to 4×10¹⁷ atoms/cm² in accordance with a specification of the SOI substrate and others. Incidentally, in case of fabricating the SOI substrate based on the SOITEC method, when the dose amount of the hydrogen ion exceeds 1×10¹⁷ atoms/cm², surface roughness of the SOI layer obtained at a subsequent step occurs, and hence the dose amount is generally set to approximately 7×10¹⁶ atoms/cm². However, according to examinations by the present inventors, it was revealed that a factor of surface roughness of the SOI layer which occurs under the ion implantation condition according to the conventional method is not the dose amount of the hydrogen ion itself but a heat treatment process at a relatively high temperature (e.g., 500°C) adopted to delaminate the silicon thin film and then obtain the SOI layer.

As explained above, when fabricating the SOI substrate based on the SOITEC method, the hydrogen ion is implanted into the bonding surface side of the silicon substrate to generate "micro cavities" at a high density, and "air bubble growth" of the "micro cavities" generated due to the heat treatment at a relatively high temperature is utilized to thermally delaminate the silicon thin film. Here, since the "air bubble growth" is exactly a diffusion phenomenon of hydrogen atoms, diffusion of hydrogen atoms prominently occurs in a process where the "air bubbles" with a very high density which are formed under a high dose condition "grow". Further, it must be interpreted that such an atom diffusion phenomenon provokes surface roughness of the SOI layer.

Therefore, when a consistent low-temperature process including the hydrogen ion implantation step is realized like the present invention, the hydrogen ion implantation step as well as a delamination step is carried out at a low temperature, and diffusion of hydrogen atoms is considerably suppressed at the delamination processing step, thereby provoking no surface roughness of the SOI layer even if hydrogen ion implantation with a high dose amount is effected. Although the present inventors performed hydrogen ion implantation with various dose amounts to check an influence on surface roughness of the SOI layer, surface roughness was not recognized up to a dose amount of at least 4×10¹⁷ atoms/cm² as long as delamination of the silicon thin film is performed in the low-temperature heat treatment at 400°C or below.

A depth (the average ion implantation depth L) of the ion implantation layer 12 from the surface of the single-crystal Si substrate 10 (an interface between itself and the oxide film 11) is controlled by an acceleration voltage in ion implantation and determined depending on a thickness of the SOI layer to be delaminated, the average ion implantation depth L is set to 0.5 µm or below and the acceleration voltage is set to 50 to 100 KeV, for example. It is to be noted that an insulating film, e.g., an oxide film may be formed on the ion implantation surface of the single-crystal Si substrate 10 in advance and the ion may be implanted through this insulating film, which is usually carried out to suppress channeling of the implanted ion in the ion implantation process with respect to the inside of the Si crystal.

After this hydrogen ion implantation, a heat treatment is carried out with respect to the single-crystal Si substrate 10 at a temperature of 400°C or below (FIG. 1(D)). This heat treatment is performed prior to the delamination step to reduce mechanical strength of an "implantation interface" of the ion implantation layer 12 in advance, and the heat treatment temperature is set to 400°C or below in order to suppress occurrence of the "micro cavities" and "air bubble growth" as explained above. When such a heat treatment is performed, the mechanical strength at the "implantation interface" is reduced and, on the other hand, an increase in "roughness" of the SOI film surface obtained by delamination of the "implantation interface" at a subsequent step can be avoided. Since the strength of the "implantation interface" is reduced at the end of the heat treatment step, "bonding strength" which is required at the subsequent delamination step relatively decreased, thereby assuring the sufficient bonding strength from later-explained surface activation treatment alone which is carried out before bonding.

A plasma treatment or an ozone treatment intended to clean the surface or activate the surface is performed with respect to the joint surfaces of the single-crystal Si substrate 10 having the ion implantation layer 12 formed thereon and the quartz substrate 20 in this manner (FIG. 1(E)). It is to be noted that such a surface treatment is performed to remove organic substances on the surfaces serving as the joint surfaces or activate the surfaces based on an increase in OH group, the treatment does not always have to be effected to the joint surfaces of both the single-crystal Si substrate 10 and the quartz substrate 20, and it may be effected to the joint surface of one of the substrates.

When performing this surface treatment based on the plasma treatment, the single-crystal Si substrate and/or the quartz substrate each having the surface cleaned by, e.g., RCA cleaning in advance is mounted on a sample stage in a vacuum chamber, and a plasma gas is introduced into the vacuum chamber so as to have a predetermined degree of vacuum. It is to be noted that, as a plasma gas type used in this example, there is, e.g., an oxygen gas, a hydrogen gas, an argon gas, a mixed gas containing these gases, or a mixed gas containing the hydrogen gas and a helium gas. After introducing the plasma gas, a high-frequency plasma having an electric power of approximately 100 W is produced, and the treatment is effected to the surface of the single-crystal Si substrate and/or that of the quartz substrate for approximately 5 to 10 seconds, thereby terminating the treatment.

When performing the surface treatment based on the ozone treatment, the single-crystal Si substrate and/or the quartz substrate each having the cleaned surface is mounted on the sample stage in the chamber having an atmosphere containing oxygen, the plasma gas, e.g., a nitrogen gas or an argon gas is introduced into the chamber, then a high-frequency plasma having a predetermined electric power is generated, oxygen in the atmosphere is converted into ozone, and the treatment is carried out to the surface of the single crystal Si substrate and/or that of the quartz substrate as a treatment target for a predetermined time.

The single-crystal Si substrate 10 and the quartz substrate 20 subjected to such a surface treatment are appressed against and bonded to each other with their surfaces being determined as the joint surfaces (FIG. 1(F)). As explained above, the surface (the joint surface) of at least one of the single-crystal Si substrate 10 and the quartz substrate 20 is subjected to the surface treatment based on the plasma treatment or the ozone treatment to be activated, thereby obtaining bonding strength which can sufficiently resist against mechanical delamination or mechanical polishing at a subsequent step even in a state where these substrates are appressed against (bonded to) each other at a room temperature.

It is to be noted that a step of performing a heat treatment at a temperature lower than a temperature of the heat treatment at the step depicted in FIG. 1(D) in a state where the single-crystal Si substrate 10 is bonded to the quartz substrate 20 may be provided after the bonding step shown in FIG. 1(F) and before the delamination step. A primary object of this heat treatment step is obtaining an effect of increasing the bonding strength of (the oxide film 11 formed on) the single-crystal silicon substrate 10 and the quartz substrate 20.

Setting a temperature at this heat treatment step to 350°C or below is preferable. As main reasons for this setting, prevention of occurrence of the "micro cavities", a damage amount due to a difference in thermal expansion coefficient between the single-crystal silicon and the quartz, and the thicknesses of the single-crystal silicon substrate 10 and the quartz substrate 20 are considered.

It is to be noted that a secondary effect of producing a thermal stress due to a difference in thermal expansion coefficient between both the single-crystal Si substrate 10 and the quartz substrate 20 to thereby weaken chemical bonding of silicon atoms in the ion implantation layer 12 can be also expected from this heat treatment depending on an implantation amount of the hydrogen ion.

After such a treatment, an external impact shock is given to the bonded substrate by any method to mechanically delaminate the silicon film 13 from a bulk 14 of the single-crystal silicon, thereby obtaining the SOI film provided on the quartz substrate 20 via the oxide film 11 (FIG. 1(G)). It is to be noted that various kinds of methods are present as a technique of giving the impact shock from the outside to delaminate the silicon thin film, but this delamination is carried out without heating in this embodiment.

Measuring a region of 10 µm × 10 µm on the surface of the thus obtained SOI film after delamination by using an atomic force microscope (AFM), an average value of RMS is 5 nm or below, which is excellent. Furthermore, a variation (PV) of the SOI film in the substrate surface is 4 nm or below. Such a relatively smooth delaminated surface is obtained because a delamination mechanism is different from that in conventional thermal delamination.

### Example 2

This embodiment is an example of examining the thickness of an oxide film when the oxide film is provided on a main surface of a silicon substrate 10.

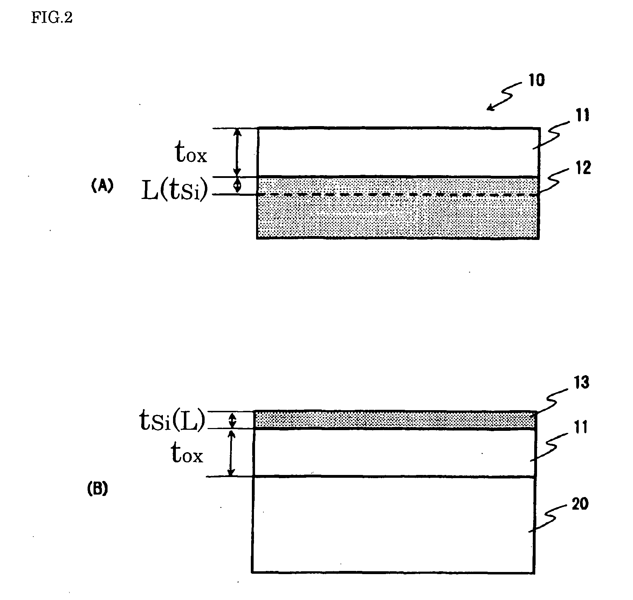

FIGS. 2 are a cross-sectional view (FIG. 2(A)) for explaining an outline of a state of a bonding surface of a single-crystal Si substrate used in the method for manufacturing an SOI substrate according to the present invention, and a cross-sectional schematic view (FIG. 2(B)) of the SOI substrate including a silicon film obtained by delamination.

As shown in FIG. 2(A), a silicon oxide film 11 having a film thickness t_{OX} is provided on one main surface (a bonding surface) of a single-crystal Si substrate 10, and a hydrogen ion implanted layer 12 is formed with an average ion implantation depth L near a substrate surface. In this embodiment, the film thickness t_{OX} of the oxide film 11 is set to 0.2 µm or above in order to suppress occurrence of a transcribe defect or a slip dislocation at a delamination step of a silicon thin film after the single-crystal Si substrate 10 is bonded to a quartz substrate.

At the delamination step after bonding the single-crystal Si substrate 10 to the quartz substrate 20, delamination of the silicon thin film occurs at a position of the average ion implantation depth L denoted by reference numeral 12 in FIG. 2(A), and this silicon thin film is transferred onto the quartz substrate 20 via the oxide film 11 to become an SOI film 13 (FIG. 2(B)).

However, the bonding surface of the quartz substrate 20 is not an ideal completely flat surface, because it has microscopic roughness or surface irregularities or, e.g., fine particles adhere to the bonding surface. When the quartz substrate 20 having such a bonding surface is bonded to the single-crystal Si substrate 10, the surface irregularities and others of the quartz substrate 20 are reflected to produce a local "gap" in the bonding surface, and a region on which a damage is apt to be concentrated is thereby generated.

A heat treatment is performed at a relatively high temperature at the "actual bonding" step for increasing the bonding strength and atomic rearrangement of Si and O locally occurs on the joint surface of the quartz substrate 20 and the oxide film 11 to alleviate damage concentration during this heat treatment in the conventional method but, since a heat energy which alleviates such a local damage based on the atomic rearrangement is not supplied from the outside when fabricating the SOI substrate in a consistent low-temperature process like the present invention, when the single-crystal Si substrate 10 is bonded to the quartz substrate 20 and the silicon thin film is delaminated by giving, e.g., an impact shock from the outside, a defect, e.g., a slip dislocation or a transcribe failure can be generated due to local damage concentration in which the surface irregularities and others of the quartz substrate 20 are reflected.

According to the method for manufacturing the SOI substrate of the present invention, since the low-temperature process is adopted for the purpose of suppressing occurrence of a thermal damage (a thermal stress) due to a difference in thermal expansion coefficient between the silicon substrate and the quartz substrate, a heat treatment at a relatively high temperature intended to improve the bonding strength of both the substrates like the conventional method is not employed, but the film thickness t_{OX} of the oxide film 11 is set to a large value, i.e., 0.2 µm or above to provide the sufficient mechanical strength to the thin film delaminated from the single-crystal silicon substrate side and to absorb/alleviate a damage by the oxide film having a relatively large film thickness, thereby suppressing generation of a transcribe defect at the delamination step.

In the present invention, as a main reason for setting the film thickness t_{OX} of the oxide film 11 to 0.2 µm or above, a total thickness of the thin film (i.e., the oxide film and the silicon film) delaminated from the single-crystal Si substrate side is increased to enhance the mechanical strength and to absorb/alleviate a damage by the oxide film, and generation of the "transcribe defect" at the delamination step is thereby suppressed. It is to be noted that the thickness of oxide film, i.e., 0.2 µm or above selected in the present invention is an empirically obtained value which is effective to prevent, e.g., the transcribe defect or the slip dislocation produced from the bonding interface from reaching the silicon thin film.

Since the mechanical strength of the thin film delaminated from the single-crystal Si substrate side when delaminating the silicon film to be transferred onto the quartz substrate is dependent on a total film thickness of the silicon thin film having a thickness t_{Si} (= L) and the oxide film having the thickness t_{OX}, generation of the "transcribe defect" such as a void at the delamination step can be suppressed when the total film thickness (t_{Si} + t_{OX}) of the silicon film and the oxide film is larger.

For example, in a case where the thickness of the oxide film 11 is as small as approximately 0.1 µm, when particles are interposed between this oxide film 11 and the bonding surface of the quartz substrate 20 and a local "gap" is generated in the bonding surface, a damage is apt to be concentrated in a corresponding region and the transcribe defect or the slip dislocation is thereby readily produced based on this, but the damage is alleviated in the oxide film 11 if the thickness of the oxide film 11 is set to 0.2 µm or above, thus reducing a stress load on the silicon film (the SOI film) provided on the oxide film 11.

### INDUSTRIAL APPLICABILITY

The present invention can reduce a temperature in the manufacturing process of the SOI substrate, suppress surface roughness of the SOI film, and provide the high-quality SOI substrate.

## Claims

1. A method for manufacturing an SOI substrate, comprising:
an ion implantation step of forming a hydrogen ion implanted layer on a main surface of a silicon substrate;
a surface treatment step of performing an activation treatment to the main surface of at least one of an insulator substrate and the silicon substrate;
a bonding step of bonding the main surfaces of the insulator substrate and the silicon substrate to each other; and
a delamination step of mechanically delaminating a silicon thin film from the silicon substrate of the bonded substrate to form a silicon film on the main surface of the insulator substrate,
wherein a temperature of the silicon substrate at the ion implantation step is maintained at 400°C or below.

2. The method for manufacturing an SOI substrate according to claim 1, comprising a step of performing a heat treatment to the silicon substrate at a temperature equal to or below 400°C after the ion implantation step and before the bonding step.

3. The method for manufacturing an SOI substrate according to claim 1, wherein a temperature of the silicon substrate at the ion implantation step falls within the range of 200°C to 400°C.

4. The method for manufacturing an SOI substrate according to any one of claims 1 to 3, wherein the activation treatment is carried out based on at least one of a plasma treatment and an ozone treatment.

5. The method for manufacturing an SOI substrate according to any one of claims 1 to 4, comprising a step of performing a heat treatment at a temperature of 400°C or below in a state where the insulator substrate and the silicon substrate are bonded to each other after the bonding step and before the delamination step.

6. The method for manufacturing an SOI substrate according to any one of claims 1 to 5, wherein the silicon substrate has a silicon oxide film on the main surface thereof.

7. The method for manufacturing an SOI substrate according to claim 6, wherein a thickness of the silicon oxide film is 0.2 µm or above.

8. The method for manufacturing an SOI substrate according to any one of claims 1 to 7, wherein the insulator substrate is any one of a high resistivity silicon substrate, a silicon substrate with an oxide film, a quartz substrate, a sapphire substrate, a glass substrate, and an organic film substrate.
